(19) **Europäisches Patentamt / European Patent Office / Office européen des brevets**

(11) **EP 3 249 949 B1**

(12) **FASCICULE DE BREVET EUROPEEN**

(45) Date de publication et mention de la délivrance du brevet:
**04.09.2019 Bulletin 2019/36**

(51) Int Cl.:
*H04R 3/00* (2006.01)     *H04R 3/02* (2006.01)
*H04R 3/08* (2006.01)

(21) Numéro de dépôt: **17156045.1**

(22) Date de dépôt: **03.03.2015**

(54) **DISPOSITIF ET PROCEDE DE FILTRAGE DU PIC DE RESONANCE DANS UN CIRCUIT D'ALIMENTATION D'AU MOINS UN HAUT-PARLEUR**

VORRICHTUNG UND VERFAHREN ZUR FILTERUNG DER RESONANZ-SPITZE IN DER STROMVERSORGUNG VON MINDESTENS EINEM LAUTSPRECHER

DEVICE AND METHOD FOR FILTERING THE RESONANCE PEAK IN THE POWER SUPPLY CIRCUIT OF AT LEAST ONE SPEAKER

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **04.03.2014 FR 1400569**

(43) Date de publication de la demande:
**29.11.2017 Bulletin 2017/48**

(62) Numéro(s) de document de la (des) demande(s) initiale(s) en application de l'article 76 CBE:
**15714245.6 / 3 114 855**

(73) Titulaires:
- **Université du Maine**
  **72085 Le Mans Cédex (FR)**
- **Centre National de la Recherche Scientifique (CNRS)**
  **75016 Paris (FR)**
- **Whylot SAS**
  **46100 Cambes (FR)**

(72) Inventeurs:
- **GAVIOT, Etienne**
  **72100 LE MANS (FR)**
- **ERZA, Mehran**
  **72000 LE MANS (FR)**
- **POLET, Frédéric**
  **72000 LE MANS (FR)**
- **CAMBERLAIN, Lionel**
  **72000 LE MANS (FR)**
- **RAVAUD, Romain**
  **46100 CORN (FR)**

(74) Mandataire: **Cabinet Le Guen Maillet**
**3, impasse de la Vigie**
**CS 71840**
**35418 Saint-Malo Cedex (FR)**

(56) Documents cités:
**GB-A- 2 068 680     GB-A- 2 473 921**

- **Esa Meriläinen: "Current-driving of loudspeakers - Eliminating major distortion and interference effects by the physically correct operation method", 8 février 2010 (2010-02-08), U.S.A., XP002734338, ISBN: 1450544002 * Chapitre 8; page 146 - page 174 * * figures 8.5, 8.11, 8.13, 8.14 ***

**Description**

La présente invention concerne un dispositif et un procédé de filtrage du pic de résonance dans un circuit d'alimentation d'au moins un haut-parleur.

On sait qu'un haut-parleur classique comprend un actionneur électromagnétique, le plus souvent composé d'un bobinage disposé sur un équipage mobile au sein d'un champ magnétique généré par un aimant permanent.

Lorsque le bobinage du haut-parleur est parcouru par un courant modulé en fréquence, le déplacement mécanique induit à fréquence audible est transformé en champ acoustique au moyen d'une membrane jouant le rôle de surface émissive, également appelée radiateur acoustique.

La qualité sonore du haut-parleur dépend de la courbe de réponse en fréquence, c'est-à-dire une réponse mécanique en accélération à une sollicitation électrique soit en courant soit en tension, que l'on recherche la plus constante possible sur l'ensemble de la bande passante. La qualité sonore dépend aussi de la linéarité du dispositif marquée par la présence d'un minimum de distorsions harmoniques et d'intermodulations.

Si le transducteur agissant en tant que haut-parleur favorise d'égale manière toutes les fréquences, la reproduction du timbre d'un instrument de musique, constitutif des harmoniques utiles du son, semble a priori pouvoir être assurée.

Toutefois, la réalité se révèle plus complexe, compte tenu de la nécessité de reproduire convenablement les transitoires d'attaque des sons représentatifs de la signature acoustique des instruments de qualité. La réponse du haut-parleur aux transitoires est une condition essentielle de "fidélité" que l'on peut tester en détectant le "traînage" de la membrane lorsque le haut-parleur est sollicité par un train d'impulsions. L'inertie de l'équipage mobile et les forces dues aux phénomènes d'auto-induction participent à ce défaut.

Les mesures acoustiques, optiques et électriques montrent qu'il n'existe pas de haut-parleur idéal et que chaque réalisation présente des défauts en termes de limitation de bande passante, pointes de résonance diverses et d'inertie. Le couplage de plusieurs transducteurs permet en principe de pallier de nombreux défauts, mais, à l'inverse, il arrive parfois de voir les défauts cumulés de façon rédhibitoire pour une reproduction musicale de qualité.

Dans un haut-parleur, la force motrice utile à l'origine du déplacement de l'équipage mobile résulte de l'interaction du champ d'induction magnétique, noté B, avec chaque élément de longueur du bobinage traversé par un courant noté i(t) fonction d'un temps t. Sur le plan local, la force élémentaire appliquée sur un porteur de charge en déplacement au sein d'un champ d'induction est qualifiée de force de Lorentz et s'exerce dans une direction perpendiculaire au plan défini par le champ et la vitesse des porteurs. Un bilan au sein d'un volume élémentaire porteur de charges assujetti au phénomène conduit à l'expression :

$$F = i.\int_0^l \vec{B}.d\vec{l} = B.l.i \qquad \textbf{(1)}$$

Tout se passe comme si la longueur déroulée du bobinage, notée l, était exposée à un champ d'induction magnétique homogène, ce qui permet de définir la quantité Bl = B.l appelée facteur de force (en Newton par Ampère ou en Tesla.mètre) de la partie motrice du haut-parleur.

Cette force, modulée par l'intensité, sollicite l'équipage mobile dont le comportement mécanique est dicté par trois composantes : une force d'inertie, produit de la masse des parties en mouvement notée $M_m$ par l'accélération imposée, une force d'amortissement, généralement considérée proportionnelle à la vitesse de déplacement via une constante notée $f_m$ en newton/m/s ou kg/s et une force de rappel liée la mécanique de suspension affectée d'une raideur notée $k_m$ en N/m. Pour une translation guidée sur un axe x l'équation de comportement d'un tel transducteur idéalisé s'écrit :

$$F = B_l.i = M_m.\frac{d^2 x}{dt^2} + f_m.\frac{dx}{dt} + k_m.x \qquad \textbf{(2)}$$

La relation courant-tension aux bornes du haut-parleur est régie par sa structure caractérisée par l'équipage mobile en mouvement au sein d'un champ magnétique. Ainsi, le comportement électrique est dicté par deux mécanismes, à savoir la dissipation par effet Joule liée à la loi d'Ohm et les interactions électromagnétiques en termes de forces électromotrices induites, sous-tendus par trois contributions :

- la chute de tension liée à la composante résistive de l'enroulement solénoïde de l'équipage,
- la force électromotrice induite liée à la variation du flux magnétique lors du déplacement,
- la force électromotrice d'auto-induction régie par la loi de Lenz.

Ainsi, dans l'hypothèse de linéarité du système, à l'équation précédemment indiquée régissant le comportement mécanique du haut-parleur, une équation de comportement électrique vient s'ajouter :

$$e_{(t)} = R_e \cdot i_{(t)} + L_e \cdot \frac{di}{dt} + B_l \cdot \frac{dx}{dt} \qquad (3)$$

Pour laquelle $R_e$ est la composante résistive pure de l'enroulement, susceptible de varier avec la température mesurée en Ohms et $L_e$ son inductance propre fonction du déplacement mesurée en Henry lorsque l'on tient compte des non linéarités. De fait, si le courant impliqué dans le membre de gauche de la deuxième équation découle directement de la troisième équation, alors toute perturbation ou non linéarité impliquée dans cette dernière entraîne une influence sur le déplacement de la membrane et ses fonctions dérivées.

Il existe deux stratégies respectives de pilotage d'un haut-parleur, à savoir un pilotage en courant ou un pilotage en tension. Si, dans les deux cas, le traitement des signaux par les étages de pré-amplification conduisent à un signal de commande systématiquement mesurable sous la forme d'une tension, dans le cas d'une commande en tension, celle-ci est naturellement dépendante de l'impédance du dipôle que représente le transducteur faisant office de haut-parleur. Ce pilotage s'apparente à une liaison entre générateurs de Thévenin idéaux débitant sur le haut-parleur. Le haut-parleur constitue alors une charge tributaire d'une alimentation par impédance quasi-nulle et toute composante de force électromotrice ou f.e.m générée influence directement le courant traversant l'association.

A l'inverse, pour une commande en courant, la transduction tension courant est assurée par un conditionneur de signal spécifiquement agencé, le transducteur étant sollicité par le courant de sortie de ce conditionneur. Ce pilotage est assimilable à un générateur de Norton idéal débitant sur le transducteur : ce dernier représente alors une charge sollicitée sous impédance infinie, sur laquelle toute fluctuation de f.e.m. générée par la charge reste sans conséquence sur le comportement de l'association. Mieux encore, cette tension peut être mesurée puis utilisée en signal de correction dans une stratégie d'asservissement.

D'une manière générale le pilotage par commande en tension sollicite directement les haut-parleurs, compte tenu d'un comportement électrique assujetti aux paramètres constitutifs de son impédance. Ce n'est que relativement récemment que divers travaux ont été conduits pour la conception de haut-parleurs spécifiquement pilotés en courant, compte tenu de conditionneurs adéquats.

Parmi les paramètres électriques et mécaniques représentatifs du comportement d'un haut-parleur, les trois grandeurs Bl, $R_e$, $L_e$ précédemment mentionnées déterminent fondamentalement la qualité de reproduction de l'association conditionneur et transducteur. Les interactions ne seront pas les mêmes selon le choix réalisé par le concepteur parmi les deux modes de pilotage en courant et en tension.

Lors d'un pilotage en courant, l'association conditionneur-transducteur reste par nature totalement immune vis-à-vis des tensions générées. Pour un tel choix, il convient toutefois de détecter et de corriger si possible les défauts inhérents à l'altération des paramètres impliqués dans l'équation (2) qui en réalité présente un terme parasite de force fonction de l'intensité au carré ou $i^2$ dite solénoïde selon la formule :

$$B_l \cdot i + \frac{1}{2} \cdot i^2 \cdot \frac{dL_e}{dx} = M_m \cdot \frac{d^2 x}{dt^2} + f_m \cdot \frac{dx}{dt} + k_m \cdot x \qquad (4)$$

L'équation (2) peut s'écrire dans le domaine fréquence par :

$$B_l \cdot I = M_m \cdot p^2 \cdot X + f_m \cdot p \cdot X + k_m \cdot X = M_m \left[ p^2 + \frac{f_m}{M_m} \cdot p + \frac{k_m}{M_m} \right] \cdot X \qquad (5)$$

où X désigne la transformée du déplacement selon Laplace et I désigne I fois l'unité, le rapport $f_m/M_m$ étant représentatif de l'atténuation qui est la fonction inverse du temps de relaxation, alors que $k_m/M_m$ traduit le carré de la fréquence angulaire de résonance.

En notant $f_m/M_m = 2/\tau$ et $k_m/M_m = \omega_0^2$, $\omega_0$ étant la vitesse angulaire initiale, la fonction de transfert du déplacement rapportée au courant s'exprime :

$$\frac{X}{I} = \frac{B_l}{M_m} \cdot \frac{1}{\left( p^2 + \frac{2}{\tau} \cdot p + \omega_0^2 \right)} = \frac{B_l}{M_m} \cdot \frac{1}{(p-a)(p-b)} = \frac{B_l}{M_m} \cdot \frac{1}{P_1} \qquad (6)$$

Les équations (2) et (3) peuvent être considérées dans le domaine fréquence en régime harmonique et combinées entre elles en termes de fonctions de transfert cascadées. En notant $E_0$ et $I_0$ les grandeurs complexes découplées de leur partie évolutive, l'indice étant significatif d'une fréquence angulaire particulière aussi appelée « phasors » en anglais, on obtient :

$$E_0 = I_0 \cdot (R_e + L_e \cdot p) + B_l \cdot (X \cdot p)$$

$$B_l \cdot I_0 = M_m \cdot p \cdot (p \cdot X) + f_m \cdot (p \cdot X) + \frac{k_m}{p} \cdot (p \cdot X) \quad \text{soit} \quad (p \cdot X) = B_l \cdot I_0 / \left| M_m \cdot p + f_m + \frac{k_m}{p} \right|$$

Après substitution du produit p.X dans la première relation, la fonction de transfert d'impédance apparaît immédiatement sous une forme composite impliquant deux termes :

$$\frac{E_0}{I_0} = Z_{HP} = (R_e + L_e \cdot p) + \frac{B_l^2}{M_m} \cdot \frac{p}{\left( p^2 + \frac{f_m}{M_m} \cdot p + \frac{k_m}{M_m} \right)} \tag{7}$$

Si la composante de réactance est négligée, alors l'impédance du haut-parleur peut être écrite :

$$Z_{HP} \approx R_e + \frac{B_l^2}{M_m} \cdot \frac{p}{\mathsf{P_1}} = \frac{R_e \cdot M_m \cdot \mathsf{P_1} + B_l^2 \cdot p}{M_m \cdot \mathsf{P_1}} \tag{7a}$$

Le regroupement des paramètres conduit alors à la forme simple suivante :

$$\left[ \frac{X}{E} \right]_p = \frac{B_l}{M_m \cdot R_e} \cdot \frac{1}{\left[ p^2 + \left( \frac{f_m + B_l^2 / R_e}{M_m} \right) \cdot p + \omega_0^2 \right]} = \frac{B_l}{M_m \cdot R_e} \cdot \frac{1}{\mathsf{V_1}} \tag{7b}$$

Il apparaît immédiatement que le polynôme $\mathsf{V_1}$ qui est celui représentatif du comportement lié au pilotage en tension est caractérisé par un amortissement a fortiori plus marqué que celui du polynôme $\mathsf{P_1}$ associé au régime de commande en courant. Au coefficient de frottement visqueux $f_m$ d'un régime de commande en courant est substitué pour un régime de commande en tension un coefficient systématiquement majoré tel que :

$$f_{m+e} = \left( f_m + B_l^2 / R_e \right) > f_m \tag{8}$$

Au regard des temps propres respectivement impliqués ($\tau_m$ et $\tau_{m+e}$), il est défini des facteurs de résonance mécanique $Q_m$ et $Q_{m+e}$, tels que :

$$Q_m = \frac{\omega_0 \cdot \tau_m}{2} = \frac{\sqrt{k_m \cdot M_m}}{f_m} \quad \text{et} \quad Q_{m+e} = \frac{\omega_0 \cdot \tau_{m+e}}{2} = \frac{\sqrt{k_m \cdot M_m}}{f_m + B_l^2 / R_e} \tag{9 et 9a}$$

Un coefficient spécifiquement électrique $Q_e$ peut donc être défini en faisant tendre $f_m$ vers zéro et une relation simple couplant les facteurs de résonance peut alors s'écrire :

$$\frac{1}{Q_{m+e}} = \frac{1}{Q_m} + \frac{1}{Q_e} \tag{10}$$

L'impédance du transducteur combine une composante exclusivement électrique avec une seconde composante appelée impédance motionnelle. Ainsi, l'impédance du haut-parleur $Z_{HP}$ s'écrit $Z_{HP}= Z_e + Z_m$ avec :

$$Z_e = \left(R_e + L_e \cdot p\right), \text{ et } Z_m = \frac{B_l^2}{M_m} \cdot \frac{p}{\left(p^2 + \frac{f_m}{M_m} \cdot p + \frac{k_m}{M_m}\right)} = \frac{B_l^2}{M_m} \cdot \frac{p}{\mathsf{P}_1} \qquad (11, 11a)$$

Il apparaît que l'impédance motionnelle est affectée par un polynôme caractéristique d'ordre deux marquant un comportement de type passe-bande. En outre, si l'usage désigne la valeur nominale de l'impédance par une valeur donnée, souvent 4W et 8W pour les transducteurs de puissance, 16W et 32W pour les mini et microsystèmes équipant les casques, la contribution de l'impédance motionnelle n'est en aucun cas négligeable lorsque le transducteur doit être sollicité en tension. De même, lorsque la fréquence augmente, la composante inductive de réactance j.L.w vient atténuer progressivement la reproduction des signaux.

Le comportement d'un transducteur sollicité en mode tension fait apparaître le couplage des relations 8 et 9b associées en termes de fonctions de transfert composites. Considérant ici la fonction relative au déplacement X(p), en reprenant les notations précédentes de l'équation (6):

$$\left[\frac{X}{I}\right]_p = \frac{B_l}{M_m} \cdot \frac{1}{\mathsf{P}_1} \text{ avec } \mathsf{P}_1 = \left(p^2 + \frac{2}{\tau}.p + \omega^2_0\right)$$

L'équation (11) descriptive de l'impédance du transducteur entraîne par ailleurs :

$$\left[\frac{X}{E}\right]_p = \left[\frac{X}{I}\right]_p \cdot \left[\frac{I}{E}\right]_p = \frac{B_l}{M_m} \cdot \frac{1}{\mathsf{P}_1} \cdot \frac{1}{Z_{HP}} \qquad (12)$$

En conséquence, les fonctions de transfert de la vitesse du diaphragme et de l'accélération, en termes de grandeurs dérivées, s'expriment alors en deux équations:

$$\left[\frac{V}{E}\right]_p = \frac{B_l}{M_m} \cdot \frac{p}{\mathsf{P}_1} \cdot \frac{1}{Z_{HP}} \text{ et } \left[\frac{A}{E}\right]_p = \frac{B_l}{M_m} \cdot \frac{p^2}{\mathsf{P}_1} \cdot \frac{1}{Z_{HP}} \qquad (12\&12a)$$

Si l'on considère la fonction relative au déplacement, elle peut être exprimée d'une manière générale sous la forme suivante :

$$\left[\frac{X}{E}\right]_p = \frac{B_l}{M_m} \cdot \frac{1}{\mathsf{P}_1} \cdot \frac{1}{Z_{HP}} = \frac{B_l}{M_m} \cdot \frac{1}{\mathsf{P}_1} \cdot \frac{1}{\left(R_e + L_e \cdot p\right) + \frac{B_l^2}{M_m} \cdot \frac{p}{\mathsf{P}_1}} \qquad (13)$$

Une conséquence importante de cette écriture apparaît immédiatement, lorsqu'on s'intéresse aux régimes proches de la résonance, avec la nécessité d'une correction par filtrage dans le cas d'un pilotage en courant. La commande en tension permet quant à elle de bénéficier d'un avantage significatif, souvent cité comme argument définitif justifiant ce choix, avec un effet d'amortissement naturel beaucoup plus marqué que pour une commande en courant.

Le document FR-A-2 422 309 reconnaît dans sa partie introductive que pour un haut-parleur piloté en courant la membrane du haut-parleur peut être le siège de déformations ou d'ondes stationnaires à fréquence très élevées, ce qui est particulièrement désavantageux pour un pilotage en courant. Inversement, ce document reconnaît qu'un pilotage en tension n'est utilisable que dans un domaine restreint de fréquence.

Pour améliorer le pilotage en courant, ce document propose de combiner une commande en courant et un asservissement en accélération pour la gamme de fréquence recouvrant toutes les résonances mécaniques du haut-parleur. Cette solution n'a cependant jamais donné satisfaction, un asservissement en accélération n'ayant pas pu permettre de compenser toutes les résonances mécaniques propres à chaque haut-parleur.

Le document GB-A-2 473 921 divulgue dans sa partie introductive que la qualité sonore de haut-parleurs électrodynamiques peut être significativement améliorée par l'alimentation d'un haut-parleur avec un pilotage en courant au lieu d'un pilotage en tension fréquemment adopté. La commande en courant est obtenue lorsque l'impédance de la source vue par le pilote est élevée par rapport à l'impédance propre du conducteur.

Ce document reconnaît aussi, qu'en pilotage en courant, un pic de fréquence typique d'un soulèvement d'un haut-parleur en forme de cône ne peut pas être compensé en ajoutant simplement un réseau RC en parallèle avec le conducteur, la haute impédance de la source étant alors perdue.

Ce document propose donc un pilotage du haut-parleur avec une double bobine utilisée conjointement avec une impédance qui désactive l'une des bobines acoustiques à des fréquences élevées, ce qui produit la correction de la réponse requise tout en conservant une impédance relativement élevée de la source.

L'adjonction d'une double bobine requiert cependant une complète reconstitution du bobinage de commande en courant qui n'est pas habituellement double. Ceci présente un coût de conception rédhibitoire et des aménagements spécifiques pour le pilotage en courant.

Le document de Esa Meriläinen intitulé «Current-driving of loudspeakers - Eliminating major distortion and interference effects by the physically correct operation method » du 8 février 2010, USA, ISBN : 1450544002 représente l'état de la technique le plus proche. Ce document décrit un circuit d'alimentation en signaux acoustiques d'au moins un haut-parleur incorporant un dispositif de filtrage du pic de résonance dudit au moins un haut-parleur se produisant à une certaine fréquence du courant d'alimentation dudit au moins un haut-parleur, ledit circuit comprenant au moins un convertisseur non inverseur disposé en amont dudit au moins un haut-parleur présentant une borne d'alimentation positive reliée à l'alimentation d'entrée du circuit et une borne d'alimentation négative, ledit circuit comprenant aussi à la sortie dudit au moins un haut-parleur un premier circuit de masse d'instrumentation en dérivation d'une boucle en retour raccordant un point du circuit en aval du haut-parleur à la borne d'alimentation négative du convertisseur non inverseur, le dispositif de filtrage du pic de résonance dudit au moins un haut-parleur étant purement électrique sous la forme d'une impédance incorporée soit dans le premier circuit de masse d'instrumentation ou soit dans la boucle en retour, les paramètres de l'impédance étant prédéterminés en fonction du pic de résonance à filtrer dudit au moins un haut-parleur.

Conformément aux documents de l'état de la technique précédemment mentionnés, si les avantages d'un pilotage en courant d'un haut-parleur ont été reconnus, il n'a pas été mis au point jusqu'à présent des solutions permettant de remédier efficacement à deux inconvénients majeurs endémiques d'un tel pilotage en courant, à savoir :

- d'une part, la présence d'un pic de résonance qui ne peut pas rester sans être corrigé, alors qu'un pilotage en tension apporte justement une correction naturelle pour ce pic de résonance grâce aux effets de l'impédance motionnelle calée à la fréquence de résonance du transducteur,
- d'autre part, lorsque la fréquence augmente, les études de l'acoustique montrent un effet de directivité accrue du haut-parleur conduisant à un rehaussement du niveau sonore mesurable dans l'axe perpendiculaire au diaphragme, ce phénomène portant le nom anglais de « horn effect ». Là encore, lors du pilotage en tension, la composante inductive du transducteur corrige localement cet effet avant de réduire le niveau acoustique dans les fréquences les plus élevées.

Le but de la présente invention est, pour toute catégorie de haut-parleur, de corriger au moins la présence d'un pic de résonance lors d'un pilotage en courant du haut-parleur, ceci par des moyens électroniques et sans adaptation spécifique de la commande en courant du haut-parleur qui reste inchangée par rapport à celle de l'état de la technique.

A cet effet, l'invention concerne un circuit selon l'état de la technique le plus proche mentionné ci-dessus caractérisé en ce que, quand l'impédance est incorporée dans le premier circuit de masse d'instrumentation, cette impédance est sous la forme d'une résistance morte associée à une première impédance dite RLC parallèle comprenant au moins une première résistance, au moins une première inductance et au moins un premier condensateur disposés en parallèle les uns des autres, la première impédance RLC parallèle étant disposée en série avec la résistance morte dans ledit premier circuit de masse d'instrumentation, et, quand l'impédance est incorporée dans la boucle en retour, cette impédance en tant que deuxième impédance comprend une deuxième résistance associée en parallèle à au moins une deuxième inductance et au moins un deuxième condensateur, ladite au moins une deuxième inductance et ledit au moins un deuxième condensateur étant disposés en série.

L'effet technique est de pouvoir utiliser un pilotage en courant avec les avantages précédemment mentionnés tout en occultant au moins le désavantage majeur d'un pilotage en courant qui est la formation d'un pic de résonance non compensé par ce pilotage contrairement à ce qui se produit pour un pilotage en tension.

Dans la première forme de réalisation de l'invention, avantageusement, les valeurs dudit au moins un premier condensateur, de ladite au moins une première résistance et de ladite au moins une première inductance sont calculées selon des paramètres dudit au moins un haut-parleur à savoir le rapport $f_m/M_m$ représentatif de l'atténuation et le rapport $k_m/M_m$ représentatif du carré de la fréquence angulaire de résonance dudit au moins un haut-parleur selon les équations suivantes :

$$f_m/M_m = 1/R_b.C_b$$

$$k_m/M_m = 1/L_b.C_b$$

Avantageusement, la valeur de la résistance morte est calculée selon l'équation suivante :

$$R_0 = \frac{1}{C_b} \cdot \frac{1}{\sqrt{2 \cdot k_m / M_m - f_m / M_m}}$$

Avantageusement, la première impédance RLC parallèle comprend n premières inductances et n premiers condensateurs, n étant supérieur ou égal à un.

Dans la seconde forme de réalisation de l'invention, avantageusement, un deuxième circuit de masse d'instrumentation est disposé entre la deuxième impédance et le convertisseur, les premier et deuxième circuits de masse d'instrumentation incorporant respectivement une première résistance morte pour le premier circuit de masse d'instrumentation et une deuxième résistance morte pour le deuxième circuit de masse d'instrumentation.

Avantageusement, un calibrage du dispositif est réalisé en fonction de la valeur de la première résistance morte, la valeur de la deuxième résistance de la deuxième impédance étant déterminée en fonction de la valeur de la première résistance morte en étant de 10 à 100 fois supérieure à la valeur de la première résistance morte, la valeur de la deuxième résistance morte étant de 2 à 30 fois supérieure à la valeur de la première résistance morte.

Avantageusement, quand la valeur de ladite au moins une deuxième inductance dépasse une valeur de 50mH, ladite au moins une deuxième inductance est sous la forme de selfs virtuelles munies de moyens girateurs.

Pour les deux formes de réalisation précédemment mentionnées, l'impédance utilisée dans le dispositif de filtrage peut se composer au moins en partie d'éléments virtuels, notamment d'au moins une inductance virtuelle. Une telle impédance virtuelle, avantageusement une inductance virtuelle, peut être particulièrement bénéfique car elle peut être aisément modifiée sans remplacement des éléments qui la composent mais seulement par modification de leur interaction et/ou de leur fonctionnement. Une telle impédance virtuelle présente donc le grand avantage d'une adaptation aisée aux conditions de fonctionnement dudit au moins un haut-parleur, notamment mais pas uniquement pour un suivi d'une variation de la fréquence du pic de résonance due par exemple à une variation de température dudit au moins un haut-parleur ou contre une surchauffe du haut-parleur.

Ceci permet donc de compenser un inconvénient qui s'ajoute aux deux inconvénients précédemment mentionnés à savoir la formation d'un pic de résonance non compensé et l'augmentation du niveau acoustique dans les fréquences les plus élevées dans la direction de l'axe perpendiculaire du diaphragme dudit au moins un haut-parleur. De plus, la fréquence du pic de résonance peut varier avec un changement de température dudit au moins un haut-parleur. Il convient donc avantageusement de tenir compte des variations de température dudit au moins un haut-parleur, ceci notamment lors de la correction du pic de résonance, afin que cette correction soit la plus précise possible.

Tout ceci peut être compensé par une modification des paramètres de l'impédance du dispositif de filtrage, notamment de l'inductance qui peut être une inductance virtuelle. Dans ce cas, la prise en compte de la température du haut-parleur qui peut être soit mesurée soit estimée se fait automatiquement par modification respective des divers éléments qui forment l'inductance virtuelle, par exemple mais non limitativement des convertisseurs auxiliaires.

D'autres avantages et particularités de l'invention apparaîtront à la lecture de la description détaillée de mises en oeuvre et de modes de réalisation nullement limitatifs, et des dessins annexés suivants :

- la figure 1 illustre une représentation schématique d'un circuit d'alimentation en signaux acoustiques d'au moins un haut-parleur, ce circuit étant muni d'un dispositif de filtrage du pic de résonance selon une première forme de réalisation de la présente invention,
- la figure 2 illustre une représentation schématique d'un circuit comprenant un convertisseur non inverseur, ce convertisseur pouvant faire partie d'un circuit d'alimentation en signaux acoustiques d'au moins un haut-parleur selon la présente invention,
- la figure 3 illustre la première forme de réalisation du dispositif de filtrage du circuit d'alimentation en signaux acoustiques représenté à la figure 1, ce dispositif étant montré à cette figure agrandi par rapport à la figure 1,
- la figure 4 illustre les courbes de modules d'accélération lors d'un pilotage en courant respectivement avec ou sans filtrage du pic de résonance ainsi que lors d'un pilotage en tension d'un haut-parleur, le filtrage s'effectuant avec un dispositif de filtrage selon la première forme de réalisation de l'invention,
- les figures 5 et 5a illustrent respectivement des courbes des modules d'impédance et de degrés d'angle en fonction des fréquences, le filtrage s'effectuant avec un dispositif de filtrage selon la première forme de réalisation de l'invention,

- la figure 6 illustre une représentation schématique d'un circuit d'alimentation en signaux acoustiques d'au moins un haut-parleur, ce circuit étant muni d'un dispositif de filtrage du pic de résonance selon une deuxième forme de réalisation de la présente invention,

- la figure 7 illustre la deuxième forme de réalisation du dispositif de filtrage du circuit d'alimentation en signaux acoustiques représentée à la figure 6, le dispositif de filtrage étant montré à cette figure agrandi par rapport à la figure 6,

- la figure 8 illustre les courbes de modules d'accélération lors d'un pilotage en courant respectivement avec ou sans filtrage du pic de résonance ainsi que lors d'un pilotage en tension d'un haut-parleur, le filtrage s'effectuant avec un dispositif de filtrage selon la deuxième forme de réalisation de l'invention,

- la figure 9 illustre des courbes des modules d'impédance comparés respectivement du dispositif de filtrage selon la deuxième forme de réalisation de l'invention et du haut-parleur.

Conformément à la présente invention, une solution de contrôle en courant idéale viserait à trouver un mode de filtrage permettant de filtrer les deux effets, à savoir le pic de résonance et l'effet de directivité du haut-parleur sans altérer l'indice de contrôle en courant aussi connu sous la dénomination CDI. Selon la présente invention, il est aussi possible de ne filtrer que le pic de résonance en conservant de manière optimale l'indice de contrôle en courant.

L'application d'un filtre à un pilotage en courant d'un haut-parleur écarte toute structure de filtre disposée en parallèle avec le haut-parleur en raison du caractère d'impédance finie, voire même de faible valeur vue en termes de source selon Thévenin. Ceci serait susceptible d'altérer l'indice CDI de manière rédhibitoire sur une partie utile du spectre.

Comme la correction du pic de résonance ressort du comportement intrinsèque du transducteur faisant office de haut-parleur, la présente invention propose une solution passive de correction en aval dudit au moins un haut-parleur.

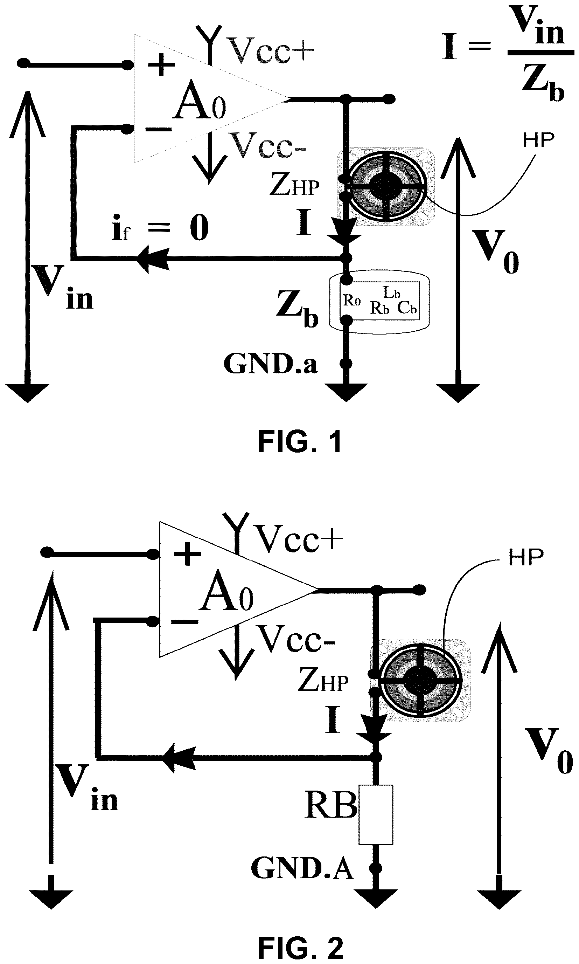

Ainsi en se référant plus particulièrement aux figures 1, 3, 6 et 7, la présente invention concerne un procédé de contrôle en courant d'un circuit d'alimentation en signaux acoustiques d'au moins un haut-parleur HP incorporant un dispositif de filtrage du pic de résonance dudit au moins un haut-parleur, dans lequel procédé il est effectué une étape de correction du pic de résonance par le dispositif de filtrage, cette étape de correction s'effectuant en aval dudit au moins un haut-parleur HP.

Avantageusement, ledit au moins un haut-parleur HP comportant un diaphragme, il est procédé simultanément au filtrage du pic de résonance à une réduction du niveau acoustique dans les fréquences les plus élevées dans la direction de l'axe perpendiculaire du diaphragme dudit au moins un haut parleur HP. Ainsi les deux inconvénients principaux d'un pilotage en courant sont traités simultanément.

Avantageusement, la réduction du niveau acoustique s'effectue en amont dudit au moins un haut-parleur HP. En effet, cette correction du niveau acoustique provient d'un phénomène physique acoustique lié à l'environnement du haut-parleur HP et relève d'un traitement d'erreur systématique qui peut faire l'objet d'une correction en amont du haut-parleur, aussi connue sous la dénomination anglaise de « feedforward correction ». Ceci présente l'avantage de ne pas altérer les propriétés du conditionnement tension courant.

Avantageusement, le facteur de résonance global du haut-parleur HP et du dispositif de filtrage prend la valeur d'un filtre de Butterworth, ce qui sera ultérieurement détaillé.

Dans la forme la plus générale de la présente invention, celle-ci concerne un circuit d'alimentation en signaux acoustiques d'au moins un haut-parleur HP incorporant un dispositif de filtrage du pic de résonance dudit au moins un haut-parleur HP se produisant à une fréquence donnée, ledit circuit comprenant au moins un convertisseur non inverseur $A_0$ disposé en amont dudit au moins un haut-parleur HP présentant une borne d'alimentation positive reliée à l'alimentation d'entrée du circuit et une borne d'alimentation négative.

Le circuit comprend aussi à la sortie dudit au moins un haut-parleur HP un premier circuit de masse d'instrumentation en dérivation d'une boucle en retour raccordant un point du circuit en aval dudit au moins un haut-parleur HP à la borne d'alimentation négative du convertisseur non inverseur $A_0$, le pic de résonance se produisant à une certaine fréquence du courant d'alimentation dudit au moins un haut-parleur HP.

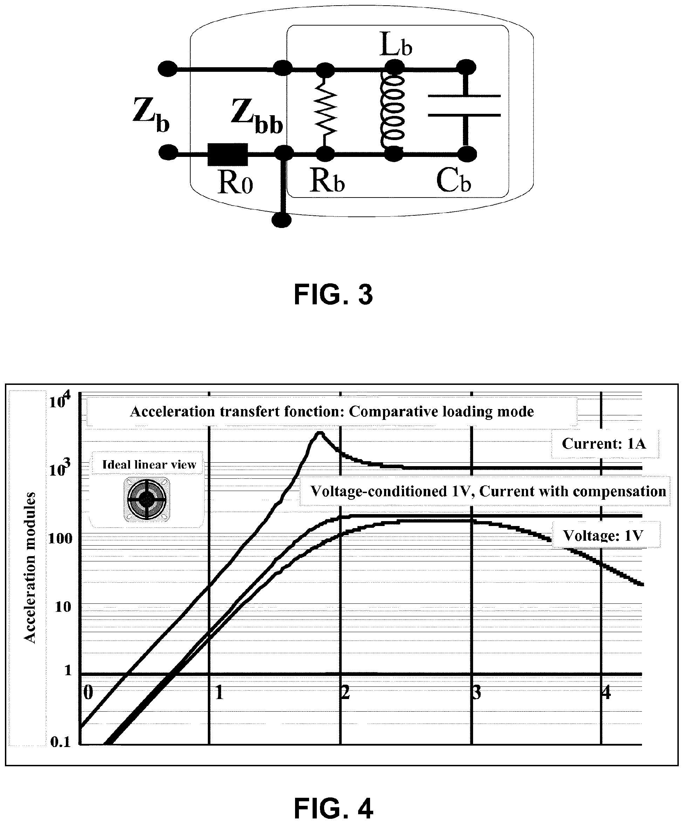

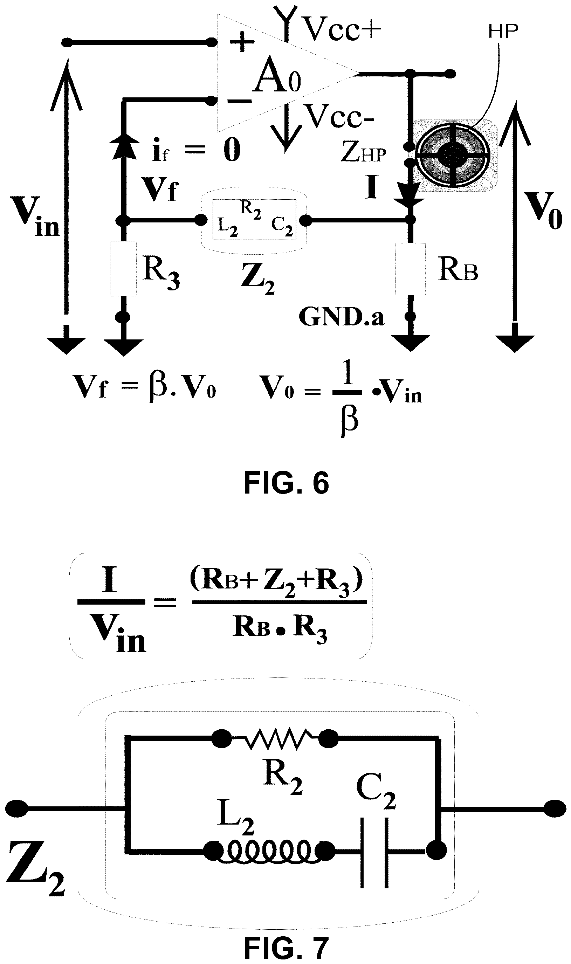

Selon une caractéristique essentielle de l'invention, un dispositif de filtrage du pic de résonance dudit au moins un haut-parleur HP est incorporé soit dans le premier circuit de masse d'instrumentation GND.a ou soit dans la boucle en retour, ce dispositif de filtrage étant purement électrique sous la forme d'une impédance, à savoir $Z_b$ montrée aux figures 1 et 3 ou $Z_2$ montrée aux figures 6 et 7. Cette impédance $Z_b$ ou $Z_2$ est incorporée dans le premier circuit de masse d'instrumentation GND.a, comme montré aux figures 1 et 3, ou dans la boucle en retour, comme montré aux figures 6 et 7. Les paramètres de l'impédance $Z_b$ ou $Z_2$ sont prédéterminés en fonction du pic de résonance à filtrer dudit au moins un haut-parleur HP.

Ainsi le dispositif de filtrage se trouve en aval du haut-parleur HP dans les deux formes de réalisation préférentielles qui vont être ci-après détaillées.

Dans la première forme de réalisation préférentielle montrée aux figures 1 et 3, le dispositif de filtrage est incorporé dans le premier circuit de masse d'instrumentation GND.a.

Comme le montre la figure 2 illustrant un convertisseur non inverseur avec une résistance $R_A$ disposée entre la sortie du convertisseur non inverseur $A_0$ et la boucle en retour au pôle du convertisseur $A_0$ et une résistance $R_B$ dans un circuit de masse d'instrumentation se trouvant en dérivation de la boucle en retour, quand la tension d'entrée du convertisseur est $V_{IN}$ et que sa tension de sortie est $V_0$, on peut écrire :

$$V_o = \left(1 + \frac{R_A}{R_B}\right) \cdot V_{in} = (R_A + R_B) \cdot I \quad \text{comme } I = \frac{V_{in}}{R_B}$$

En comparant cette équation avec l'équation (12)

$$\left[\frac{X}{E}\right]_p = \left[\frac{X}{I}\right]_p \cdot \left[\frac{I}{E}\right]_p = \frac{B_l}{M_m} \cdot \frac{1}{P_1} \cdot \frac{1}{Z_{HP}} \tag{12}$$

et en généralisant la résistance $R_B$ à une impédance notée $Z_b$, en termes de fonctions de transfert il apparaît alors :

$$\left[\frac{I}{E}\right]_p = \frac{I}{V_{in}} = \frac{1}{Z_b} \tag{13}$$

avec, comme par ailleurs:

$$\left[\frac{X}{I}\right]_p = \frac{B_l}{M_m} \cdot \frac{1}{P_1} \quad \text{où } P_1 = \left(p^2 + \frac{2}{\tau} \cdot p + \omega^2{}_0\right) \tag{6}$$

ainsi qu'il a été énoncé à l'équation (6), le contrôle en tension est assujetti à :

$$\left[\frac{X}{E}\right]_p = \left[\frac{X}{I}\right]_p \cdot \left[\frac{I}{E}\right]_p = \frac{B_l}{M_m} \cdot \frac{1}{P_1} \cdot \frac{1}{Z_{HP}} \tag{12}$$

Pour un signal de commande noté E imposé à l'entrée du convertisseur $A_0$ Courant Tension, le contrôle en courant relève d'un comportement tel que :

$$\left[\frac{X}{E}\right]_p = \left[\frac{X}{I}\right]_p \cdot \left[\frac{I}{E}\right]_p = \frac{B_l}{M_m} \cdot \frac{1}{P_1} \cdot \frac{1}{Z_b} \tag{14}$$

Une correction purement électrique peut donc se concevoir en identifiant à $Z_{HP}$ de l'équation (12) les paramètres constitutifs de $Z_b$ de l'équation (14) de telle sorte que le pic de résonance soit totalement filtré de la même manière que la correction introduite par l'équation (12).

Comme le montre la figure 3, l'impédance $Z_b$ du dispositif de filtrage est sous la forme d'une résistance morte $R_0$ associée à une première impédance dite RLC parallèle $Z_{bb}$. Cette première impédance comprend au moins une première résistance $R_b$, au moins une première inductance $L_b$ et au moins un premier condensateur $C_b$ disposés en parallèle les uns des autres, la première impédance RLC parallèle $Z_{bb}$ étant disposée en série avec la résistance morte $R_0$ dans ledit premier circuit de masse d'instrumentation.

La figure 3 illustre les éléments conduisant à développer une compensation du facteur de résonance à l'aide d'un filtre RLC parallèle disposé en série avec une résistance morte $R_0$.

Il peut convenir d'édifier une relation de comportement identifiable à l'équation (7a) :

$$Z_{HP} \approx R_e + \frac{B_l^2}{M_m} \cdot \frac{p}{P_1} = \frac{R_e \cdot M_m \cdot P_1 + B_l^2 \cdot p}{M_m \cdot P_1} \tag{7a}$$

Il est en effet possible d'égaliser respectivement les polynômes $P_1$ et le dénominateur associé à l'impédance

$Z_{bb}$ au regard des deux critères suivants $C_1$ et $C_2$:

$$C_1 : \omega_0^2 = \frac{k_m}{M_m} = \frac{1}{L_b \cdot C_b} \quad \text{et} \quad C_2 : \frac{f_m}{M_m} = \frac{1}{R_b \cdot C_b} \qquad \text{(15 et 15a)}$$

$F_m$, $k_m$ et $M_m$ ayant été définis à l'équation (5) et étant des paramètres prédéterminés du haut-parleur.

Ainsi, les valeurs dudit au moins un premier condensateur $C_b$, de ladite au moins une première résistance $R_b$ et de ladite au moins une première inductance $L_b$ sont calculées selon des paramètres du haut-parleur, à savoir le rapport $f_m/M_m$ représentatif de l'atténuation et le rapport $k_m/M_m$ représentatif du carré de la fréquence angulaire de résonance du haut-parleur HP selon les équations suivantes :

$$f_m/M_m = 1/R_b.C_b \qquad \text{(16)}$$

$$k_m/M_m = 1/L_b.C_b \qquad \text{(16a)}$$

Considérant maintenant la mise en série du réseau parallèle RLC avec la résistance $R_0$, un regroupement identique à celui conduisant à l'équation (7b) permet d'écrire la fonction de transfert en déplacement :

$$\left[\frac{X}{E}\right]_p = \frac{B_l}{M_m \cdot R_0} \cdot \frac{1}{\left[p^2 + \left(\frac{f_m}{M_m} + \frac{1}{R_0 \cdot C_b}\right) \cdot p + \omega_0^2\right]} = \frac{B_l}{M_m \cdot R_0} \cdot \frac{1}{\mathbf{W}_1} \qquad \text{(17)}$$

Cette association présente un facteur de résonance composite noté $O_{HP+Zb}$ entre le facteur mécanique de l'équation (9) noté $Q_m$ et un facteur purement électrique $Q_{Zb}$ de telle sorte que :

$$\frac{1}{Q_{HP+Zb}} = \frac{1}{Q_m} + \frac{1}{Q_{Zb}} \quad \text{avec} \quad Q_{HP+Zb} = \frac{\sqrt{k_m/M_m}}{f_m/M_m + 1/R_0 \cdot C_b} \qquad \text{(18)}$$

soit si $f_m \to 0$, alors:

$$Q_{Zb} = R_0 \cdot C_b \cdot \sqrt{k_m/M_m} \qquad \text{(19)}$$

Après avoir choisi les valeurs d'inductance $L_b$ et de condensateur $C_b$ au regard des critères $C_1$ et $C_2$, un comportement idéalisé peut être envisagé en choisissant d'agencer la résistance $R_0$ de telle sorte que le facteur de résonance global prenne une valeur optimale, celle d'un filtre selon Butterworth correspondant à $Q_{HP+Zb} = 1/\sqrt{2}$.

Ainsi :

$$R_0 = \frac{1}{C_b} \cdot \frac{1}{\sqrt{2 \cdot k_m/M_m} - f_m/M_m} \qquad \text{(20)}$$

Dans la première forme de réalisation préférentielle montrée aux figures 1 et 3, le dispositif de filtrage est donc incorporé dans le premier circuit de masse d'instrumentation GND.a. Comme précédemment mentionné, en fonction du voltage d'entrée $V_{in}$ du circuit, le courant I qui circule dans le premier circuit de masse d'instrumentation GND.a à travers de l'impédance impédance $Z_b$ est défini par I= $V_{in}/Z_b$. Le courant $I_f$ circulant dans la boucle de retour du convertisseur peut être égal à 0.

Un exemple non limitatif et purement illustratif pour un exemple de haut-parleur va maintenant être donné. Il est pris comme haut-parleur un haut-parleur Morel EM 428 avec les paramètres suivants : $L_e$= 0,36mH, $R_e$=5,4 $\Omega$, Bl= 5,4 T.m, $M_m$= 6,55 g, $k_m$=1136 N/m, $f_m$=0,86 kg/s, Résonance $F_0$ = 66,29 Hz

Les facteurs de résonance, mécaniques, électriques et combinés, mesurés et théoriques sont respectivement, le facteur théorique étant celui entre parenthèses, Qm 3,03 (3,17), Qe 0,48 (0,505), Qm+e 0,41 (0,436).

Comme défini précédemment, l'application du critère $C_1$ portant sur la fréquence de résonance est à considérer en fonction de la disponibilité et du prix des deux composants respectifs : le ou les inductances, avantageusement des selfs bobinées sur air et le ou les condensateurs bipolaires.

Au premier ordre, le choix d'une self de $L_b$ = 12 mH impose une capacité de $C_b$ =480 µF pour couvrir la fréquence de résonance de 66,3Hz. Un tel choix peut cependant être discuté, en termes de prix et de défauts propres aux composants, au regard des combinaisons possibles, notamment avec éventuellement une self n fois plus faible associée avec n condensateurs disposés en parallèle.

L'application du critère $C_2$ portant sur l'équivalence des temps de relaxation conduit à une valeur de résistance $R_b$ = 15,8 Ω. Enfin, l'équation (20) conduit à choisir une résistance série de $R_0$ = 4,55 Ω. Sans préjuger de leur aptitude à dissiper l'échauffement consécutif à un régime opérationnel avec le transducteur, de tels composants sont aisément disponibles dans le commerce.

Pour simplifier la notation, le raisonnement a porté sur la fonction de déplacement, mais c'est l'accélération qui fait l'objet de l'attention à porter quant au résultat acoustique.

Il importe de conserver la stabilité du système, quelque soit le régime de fonctionnement de l'association convertisseur et ledit au moins un haut-parleur. La relation d'impédance représentative du déphasage entre les signaux ne présente pas un déphasage proche de 180°, ce qui pourrait entraîner la mise en oscillation de l'amplificateur.

La figure 4 illustre les courbes de modules d'accélération lors d'un pilotage en courant avec ou sans filtrage du pic de résonance ainsi que lors d'un pilotage en tension d'un haut-parleur, le filtrage s'effectuant avec un dispositif de filtrage selon la première forme de réalisation de l'invention. La courbe intermédiaire est la courbe avec pilotage en courant et filtrage avec un dispositif de filtrage selon la première forme de réalisation et montre l'absence d'un pic de résonance contrairement à la courbe supérieure avec pilotage en courant sans filtrage. De plus, la courbe intermédiaire présente une plage de module d'accélération sensiblement constante plus large que celle de la courbe inférieure qui est la courbe avec pilotage en tension.

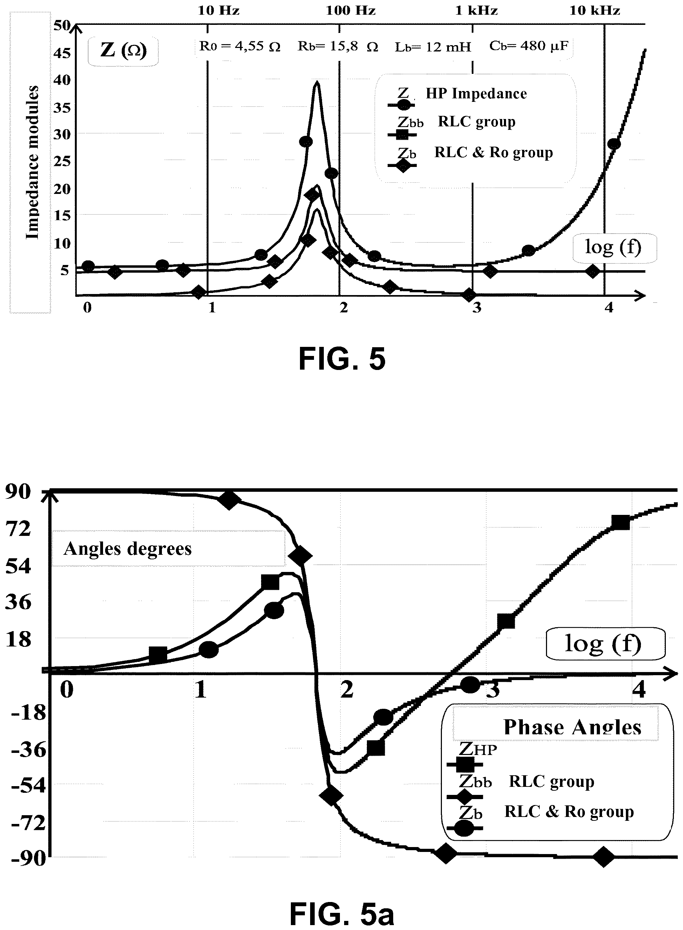

Aux figures 5, 5a pour le haut-parleur pris en exemple, il a été tracé de manière comparative respectivement les courbes des modules d'impédance $Z_{HP}$, $Z_{bb}$ et $Z_b$ et leurs degrés d'angle en fonction de la fréquence. La courbe pour le module $Z_{HP}$ est celle présentant des rectangles, celle de $Z_{bb}$ des losanges et celle de $Z_b$ des cercles. Les courbes à la figure 5a montrent ainsi que l'angle de déphasage reste dans une gamme de valeurs parfaitement admissibles, avantageusement de -40° à +40°, sur le domaine fréquentiel considéré.

La deuxième forme de réalisation du dispositif de filtrage prévoit son incorporation à la boucle en retour de l'inverseur $A_0$. Ceci est montré aux figures 6 et 7.

Le dispositif de filtrage est incorporé dans la boucle de retour et est sous la forme d'une deuxième impédance $Z_2$ comprenant une deuxième résistance $R_2$ associée en parallèle à au moins une deuxième inductance $L_2$ et au moins un deuxième condensateur $C_2$, ladite au moins une deuxième inductance $L_2$ et ledit au moins un deuxième condensateur $C_2$ étant disposés en série.

Comparé à la première forme de réalisation qui imposait le passage d'un courant fort dans le filtre $R_0$, $R_b$, $L_b$, $C_b$ comme montré à la figure 1, la deuxième forme de réalisation évite cet inconvénient en choisissant de disposer le dispositif de filtrage dans la boucle en retour du convertisseur $A_0$.

Dans cette deuxième forme de réalisation, montrée aux figures 6 et 7, dans laquelle un deuxième circuit de masse d'instrumentation est disposé entre la deuxième impédance $Z_2$ et le convertisseur $A_0$, les premier et deuxième circuits de masse d'instrumentation incorporent respectivement une première résistance morte $R_B$ pour le premier circuit de masse d'instrumentation GND.a et une deuxième résistance morte $R_3$ pour le deuxième circuit de masse d'instrumentation.

Soient $V_{in}$ le voltage d'entrée du circuit, $V_0$ le voltage de sortie du convertisseur $A_0$ et $V_f$ la tension dans la boucle de dérivation, on peut définir un facteur β tel que :

$$V_f = \beta \, V_0 \quad \text{et} \quad V_0 = 1/\beta \, V_{in}$$

Le courant $I_f$ retournant au pôle négatif du convertisseur après la dérivation de la seconde masse d'instrumentation peut être égal à 0.

Un autre calcul classique montre que la transconductance est alors définie par :

$$\frac{I}{V_{in}} = \frac{1}{R_B} \cdot \left(1 + (Z_2 + R_B)/R_3\right) \tag{21}$$

En se référant à toutes les équations précédemment mentionnées, il est possible de calculer la deuxième impédance $Z_2$, le facteur de résonance mécanique de l'impédance $Z_2$ et la vitesse angulaire initiale $\omega_0$ :

$$Z_2 = \frac{p^2 \cdot R_2 + R_2/L_2 \cdot C_2}{p^2 + \frac{R_2}{L_2} \cdot p + 1/L_2 \cdot C_2}$$

$$\omega_0 = \frac{1}{\sqrt{L_2 \cdot C_2}}$$

$$Q_{Z2} = \frac{1}{R_2} \cdot \sqrt{\frac{L_2}{C_2}}$$

Un calibrage peut être réalisé en premier lieu avec le choix de $R_B$, puis de $R_2$ très supérieur à $R_B$, puisque $R_2$ conditionne le comportement générique en dehors de la résonance. Le coefficient de qualité de cette structure de filtre exige toutefois une valeur d'inductance très supérieure à celle définie pour la solution précédente.

Par exemple, sans être limitatif, le calibrage du dispositif peut être réalisé en fonction de la valeur de la première résistance morte $R_B$, la valeur de la deuxième résistance $R_2$ de la deuxième impédance $Z_2$ étant déterminée en fonction de la valeur de la première résistance morte $R_B$ en étant de 10 à 100 fois supérieure à la valeur de la première résistance morte $R_B$, la valeur de la deuxième résistance morte $R_3$ étant de 2 à 30 fois supérieure à la valeur de la première résistance morte $R_B$.

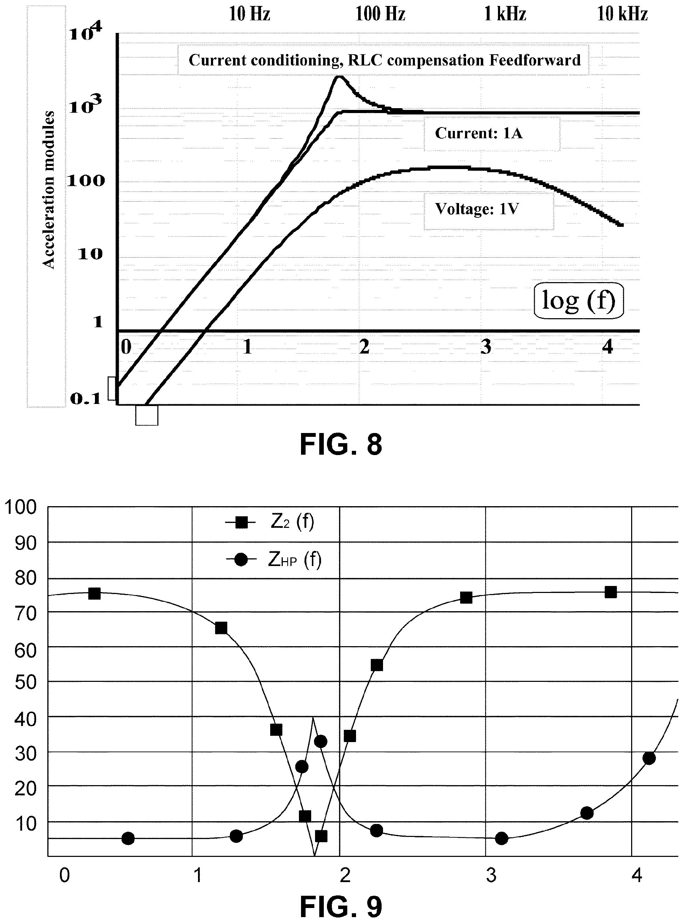

En outre, selon la structure du convertisseur $A_0$, la valeur de $R_B$ ne doit pas avantageusement être trop élevée pour maintenir la stabilité. Pour le haut-parleur utilisé en exemple, avec une valeur de $R_B$ unitaire, les comportements du dispositif de filtrage et de la transconductance sont illustrés sur la figure 8. A la fréquence de résonance, les tracés de phase soulignent la rotation de phase présentée par $Z_2$ ainsi que la symétrie observée par la transconductance comparée avec le transducteur.

Les valeurs des composants indiquées sur la figure sont ajustées pour répondre à un facteur de qualité électrique de l'ordre de 0,45 permettant une association correcte avec la résonance du transducteur.

Pour une tension de commande notée E sollicitant l'entrée du conditionneur et considérant les derniers éléments présentés affectés de leurs valeurs respectives, le comportement en accélération résultant de l'agencement s'exprime :

$$\left[\frac{A}{E}\right]_p = p^2 \cdot \left[\frac{X}{E}\right]_p = p^2 \cdot \left[\frac{X}{I}\right]_p \cdot \left[\frac{I}{E}\right]_p = p^2 \cdot \frac{B_l}{M_m} \cdot \frac{1}{P_1} \cdot \frac{1}{R_B} \cdot \left(1 + (Z_2 + R_B)/R_3\right) \quad \textbf{(22)}$$

Dans cette notation, E présente une valeur unitaire. Un gain ou une atténuation peut permettre un ajustage, soit par adjonction d'un étage en amont du conditionneur soit en modifiant la valeur de la résistance $R_B$ sous réserve de ne pas altérer la stabilité en fonction de l'amplificateur utilisé.

Aux figures, il convient de rappeler que le haut-parleur pris en exemple présente un facteur de résonance mécanique modéré de valeur $Q_m \approx 3$, valeur suffisamment faible pour permettre la correction envisagée. Le calcul montre que pour une valeur de $Q_m$ supérieure à 8, par exemple un haut-parleur Pioneer® TS-123, les modalités d'application de cette correction sont plus exigeantes. De fait, pour l'exemple choisi, cette solution requiert une inductance de 80 mH, valeur pouvant être rédhibitoire pour un enroulement sur air. Un montage de self artificielle, notamment avec des dispositifs gyrateurs, peut toutefois être envisagé, une variation d'inductance pouvant ainsi être aisément obtenue.

Un autre exemple non limitatif peut aussi être donné pour un haut-parleur présentant les caractéristiques suivantes $B_l$=2,675 Tm, $M_m$=3,67 g, $f_m$=0,539 N/m, $k_m$=5650 N/m, fréquence de résonance = 197 Hz, $R_e$=3,65$\Omega$, L=0,12 mH.

Dans ce cas, selon le premier mode de réalisation du dispositif de filtrage, La relation portant sur les critères C1 et C2 conduit par exemple à $L_b$= 2,2 mH, $C_b$=295$\mu$F, $R_b$=23$\Omega$. De même l'équivalence de Butterworth entraîne : $R_0$= 2,2$\Omega$.

Ces valeurs ne sont pas contraignantes et permettent même d'envisager des composants standards. Enfin, le résultat global est idéalisé si la transconductance nominale du conditionneur tension courant est fixée à 2A/V.

Avantageusement, les selfs servant d'inductances dans les diverses formes de réalisation exposées peuvent être réalisées en métaux ou alliages légers autres que le cuivre, le critère principal étant une bonne conductivité électrique.

La figure 8 illustre les courbes de pilotage en courant avec ou sans filtrage du pic de résonance ainsi que la courbe de pilotage en tension d'un haut-parleur, le filtrage s'effectuant avec un dispositif de filtrage selon la deuxième forme de réalisation de l'invention. La courbe intermédiaire est la courbe avec pilotage en courant et filtrage avec un dispositif de filtrage selon la deuxième forme de réalisation et montre l'absence d'un pic de résonance contrairement à la courbe supérieure avec pilotage en courant sans filtrage. De plus, la courbe intermédiaire présente une plage de module d'accélération sensiblement constante plus large que celle de la courbe inférieure qui est la courbe avec pilotage en tension.

A la figure 9 pour le haut-parleur pris en exemple, il a été tracé de manière comparative respectivement les courbes des modules d'impédance comparées du dispositif de filtrage $Z_2$ et dudit au moins un haut-parleur $Z_{HP}$. Ces courbes de modules d'impédance croissent et décroissent en opposition. La courbe présentant des rectangles illustre la courbe d'impédance $Z_2$ du dispositif de filtrage tandis que la courbe présentant des cercles illustre la courbe d'impédance $Z_{HP}$ du haut-parleur

Dans ce qui a été précédemment décrit, il a été utilisé dans le circuit au moins un convertisseur non inverseur, ceci pour simplification des calculs. Ceci n'est pas limitatif et la présente invention peut cependant aussi s'appliquer pour un circuit comprenant plusieurs convertisseurs non inverseurs de même qu'un ou plusieurs convertisseurs inverseurs.

Le marché de la reproduction audio, particulièrement de la reproduction de haut de gamme est directement concerné par les dispositifs de filtrage conformes à la présente invention. Les grandes marques, du type Boose®, Bang & Olufsen®, Harman Kardon®, B&W®, etc..., pourraient trouver un intérêt certain pour la diffusion commerciale de tels dispositifs de filtrage.

**Revendications**

**1.** Circuit d'alimentation en signaux acoustiques d'au moins un haut-parleur (HP) incorporant un dispositif de filtrage du pic de résonance dudit au moins un haut-parleur (HP) se produisant à une certaine fréquence du courant d'alimentation dudit au moins un haut-parleur (HP), ledit circuit comprenant au moins un convertisseur non inverseur ($A_0$) disposé en amont dudit au moins un haut-parleur (HP), le convertisseur présentant une borne d'alimentation positive reliée à l'alimentation d'entrée du circuit et une borne d'alimentation négative, ledit circuit comprenant aussi à la sortie dudit au moins un haut-parleur (HP) un premier circuit de masse d'instrumentation (GND.a) en aval du haut-parleur en dérivation d'une boucle en retour raccordant le point d'entrée du circuit de masse en aval du haut-parleur (HP) à la borne d'alimentation négative du convertisseur non inverseur ($A_0$), le dispositif de filtrage du pic de résonance dudit au moins un haut-parleur (HP) étant purement électrique sous la forme d'une impédance ($Z_b$, $Z_2$) incorporée soit dans le premier circuit de masse d'instrumentation (GND.a) ou soit dans la boucle en retour, les paramètres de l'impédance ($Z_b$, $Z_2$) étant prédéterminés en fonction du pic de résonance à filtrer dudit au moins un haut-parleur (HP), **caractérisé en ce que** :

- quand l'impédance ($Z_b$) est incorporée dans le premier circuit de masse d'instrumentation (GND.a), cette impédance ($Z_b$) est sous la forme d'une résistance morte ($R_0$) associée à une première impédance dite RLC parallèle ($Z_{bb}$) comprenant au moins une première résistance ($R_b$), au moins une première inductance ($L_b$) et au moins un premier condensateur ($C_b$) disposés en parallèle les uns des autres, la première impédance RLC parallèle ($Z_{bb}$) étant disposée en série avec la résistance morte ($R_0$) dans ledit premier circuit de masse d'instrumentation (GND.a), et
- quand l'impédance ($Z_2$) est incorporée dans la boucle en retour, cette impédance en tant que deuxième impédance ($Z_2$) comprend une deuxième résistance ($R_2$) associée en parallèle à au moins une deuxième inductance ($L_2$) et au moins un deuxième condensateur ($C_2$), ladite au moins une deuxième inductance ($L_2$) et ledit au moins un deuxième condensateur ($C_2$) étant disposés en série.

**2.** Circuit selon la revendication précédente, dans lequel, quand l'impédance ($Z_b$) est incorporée dans le premier circuit de masse d'instrumentation (GND.a), les valeurs dudit au moins un premier condensateur ($C_b$), de ladite au moins une première résistance ($R_b$) et de ladite au moins une première inductance ($L_b$) sont calculées selon des paramètres dudit au moins un haut-parleur (HP) à savoir le rapport $f_m/M_m$ représentatif de l'atténuation et le rapport $k_m/M_m$ représentatif du carré de la fréquence angulaire de résonance dudit au moins un haut-parleur (HP) selon les équations suivantes :

$$f_m/M_m = 1/R_b.C_b$$

$$k_m/M_m = 1/L_b.C_b$$

où $M_m$ représente la masse en mouvement du haut-parleur, $f_m$ est une constante par laquelle la force d'amortissement du haut-parleur est proportionnelle à la vitesse de déplacement du haut-parleur, et $k_m$ représente une raideur de mécanique de suspension du haut-parleur.

3. Circuit selon la revendication précédente, dans lequel la valeur de la résistance morte ($R_0$) est calculée selon l'équation suivante :

$$R_0 = \frac{1}{C_b} \cdot \frac{1}{\sqrt{2 \cdot k_m / M_m - f_m / M_m}}$$

4. Circuit selon l'une quelconque des trois revendications précédentes, dans lequel la première impédance RLC parallèle ($Z_{bb}$) comprend n premières inductances ($L_b$) et n premiers condensateurs ($C_b$), n étant supérieur ou égal à un.

5. Circuit selon la revendication précédente, dans lequel, quand l'impédance ($Z_2$) est incorporée dans la boucle en retour, un deuxième circuit de masse d'instrumentation est disposé entre la deuxième impédance ($Z_2$) et le convertisseur ($A_0$), les premier et deuxième circuits de masse d'instrumentation incorporant respectivement une première résistance morte ($R_B$) pour le premier circuit de masse d'instrumentation et une deuxième résistance morte ($R_3$) pour le deuxième circuit de masse d'instrumentation.

6. Circuit selon la revendication précédente, dans lequel un calibrage du dispositif est réalisé en fonction de la valeur de la première résistance morte ($R_B$), la valeur de la deuxième résistance ($R_2$) de la deuxième impédance ($Z_2$) étant déterminée en fonction de la valeur de la première résistance morte ($R_B$) en étant de 10 à 100 fois supérieure à la valeur de la première résistance morte ($R_B$), la valeur de la deuxième résistance morte ($R_3$) étant de 2 à 30 fois supérieure à la valeur de la première résistance morte ($R_B$).

7. Circuit selon l'une quelconque des revendications 1, 5 ou 6, dans lequel, quand la valeur de ladite au moins une deuxième inductance ($L_2$) dépasse une valeur de 50mH, ladite au moins une deuxième inductance ($L_2$) est sous la forme de selfs virtuelles munies de moyens girateurs.

**Patentansprüche**

1. Schaltung zur Versorgung mit akustischen Signalen mindestens eines Lautsprechers (HP), die eine Filtervorrichtung der Resonanzspitze des mindestens einen Lautsprechers (HP) umfasst, die bei einer bestimmten Frequenz des Versorgungsstroms des mindestens einen Lautsprechers (HP) auftritt, wobei die Schaltung mindestens einen nicht umkehrenden Wandler ($A_0$) umfasst, der stromaufwärts des mindestens einen Lautsprechers (HP) angeordnet ist, wobei der Wandler eine positive Versorgungsklemme aufweist, die mit der Eingangsversorgung der Schaltung verbunden ist, und eine negative Versorgungsklemme, wobei die Schaltung auch am Ausgang des mindestens einen Lautsprechers (HP) eine erste Instrumentenausrüstungsmasseschaltung (GND.a) stromabwärts des Lautsprechers in Abzweigung von einer Rücklaufschleife umfasst, die den Eingangspunkt der Masseschaltung stromabwärts des Lautsprechers (HP) mit der negativen Versorgungsklemme des nicht umkehrenden Wandlers ($A_0$) verbindet, wobei die Filtervorrichtung der Resonanzspitze des mindestens einen Lautsprechers (HP) rein elektrisch in der Form einer Impedanz ($Z_b$, $Z_2$) ist, die entweder in der ersten Instrumentenausrüstungsmasseschaltung (GND.a) oder in der Rückkehrschleife eingebaut ist, wobei die Parameter der Impedanz ($Z_b$, $Z_2$) in Abhängigkeit von der zu filternden Resonanzspitze des mindestens einen Lautsprechers (HP) vorbestimmt sind, **dadurch gekennzeichnet, dass**:

- wenn die Impedanz ($Z_b$) in die erste Instrumentenausrüstungsmasseschaltung (GND.a) eingebaut ist, diese Impedanz ($Z_b$) die Form eines reinen Widerstands ($R_0$) aufweist, der mit einer ersten Impedanz, parallele RCL ($Z_{bb}$) genannt, assoziiert ist, die mindestens einen ersten Widerstand ($R_b$), mindestens eine erste Induktanz ($L_b$) und mindestens einen ersten Kondensator (Cb) umfasst, die miteinander parallel geschaltet sind, wobei die erste parallele Impedanz RLC ($Z_{bb}$) in Reihe mit dem reinen Widerstand ($R_0$) in der ersten Instrumentenausrüstungsmasseschaltung (GND.a) angeordnet ist, und

- wenn die Impedanz ($Z_2$) in die Rückkehrschleife eingebaut ist, diese Impedanz als zweite Impedanz ($Z_2$) einen zweiten Widerstand ($R_2$) umfasst, der parallel mit mindestens einer zweiten Induktanz ($L_2$) und mindestens einem zweiten Kondensator ($C_2$) assoziiert ist, wobei die mindestens eine zweite Induktanz ($L_2$) und der mindestens eine zweite Kondensator ($C_2$) in Reihe angeordnet sind.

2. Schaltung nach dem vorstehenden Anspruch, wobei, wenn die Impedanz ($Z_b$) in die erste Instrumentenausrüstungsmasseschaltung (GND.a) eingebaut ist, die Werte des mindestens einen ersten Kondensators ($C_b$) des mindestens einen ersten Widerstands ($R_b$) und der mindestens einen ersten Induktanz ($L_b$) gemäß Parametern des mindestens einen Lautsprechers (HP) berechnet sind, nämlich dem Verhältnis $f_m/M_m$, das für die Dämpfung des Verhältnisses $k_m/M_m$ repräsentativ ist, das für das Verhältnis des Quadrats der Winkelresonanzfrequenz des mindestens einen Lautsprechers (HP) gemäß den folgenden Gleichungen repräsentativ ist:

$$f_m/M_m = 1/R_b.C_b$$

$$k_m/M_m = 1/L_b.C_b$$

wobei $M_m$ die Masse in Bewegung des Lautsprechers darstellt, $f_m$ eine Konstante ist, durch die die Dämpfungskraft des Lautsprechers zu der Bewegungsgeschwindigkeit des Lautsprechers proportional ist, und $k_m$ eine mechanische Aufhängungssteifigkeit des Lautsprechers darstellt.

3. Schaltung nach dem vorstehenden Anspruch, wobei der Wert des reinen Widerstands ($R_0$) gemäß der folgenden Gleichung berechnet wird:

$$R_0 = \frac{1}{C_b} \cdot \frac{1}{\sqrt{2 \cdot k_m/M_m - f_m/M_m}}$$

4. Schaltung nach einem der drei vorstehenden Ansprüche, wobei die erste parallele Impedanz RLC ($Z_{bb}$) n erste Induktanzen ($L_b$) und n erste Kondensatoren (Cb) umfasst, wobei n größer oder gleich eins ist.

5. Schaltung nach dem vorstehenden Anspruch wobei, wenn die Impedanz ($Z_2$) in die Rückkehrschleife eingebaut ist, eine zweite Instrumentenausrüstungsmasseschaltung zwischen der zweiten Impedanz ($Z_2$) und dem Wandler ($A_0$) angeordnet ist, wobei die erste und die zweite Instrumentenausrüstungsmasseschaltung jeweils einen ersten reinen Widerstand ($R_B$) für die erste Instrumentenausrüstungsmasseschaltung, und einen zweiten reinen Widerstand ($R_3$) für die zweite Instrumentenausrüstungsmasseschaltung enthalten.

6. Schaltung nach dem vorstehenden Anspruch, wobei ein Kalibrieren der Vorrichtung in Abhängigkeit von dem Wert des ersten reinen Widerstands ($R_B$) ausgeführt wird, wobei der Wert des zweiten Widerstands ($R_2$) der zweiten Impedanz ($Z_2$) in Abhängigkeit von dem Wert des ersten reinen Widerstands ($R_B$) bestimmt wird, wobei er 10 bis 100 Mal größer ist als der Wert des ersten reinen Widerstands ($R_B$), wobei der Wert des zweiten reinen Widerstands ($R_3$) 2 bis 30 Mal größer ist als der Wert des ersten reinen Widerstands ($R_B$).

7. Schaltung nach einem der Ansprüche 1, 5 oder 6, wobei, wenn der Wert der mindestens einen zweiten Induktanz ($L_2$) einen Wert von 50 mH überschreitet, die mindestens eine zweite Induktanz ($L_2$) die Form virtueller Drosselwiderstände, die mit Gyratormitteln versehen sind, aufweist.

## Claims

1. Acoustic signal supply circuit for at least one speaker (HP) incorporating a device for filtering the resonance peak of said at least one speaker (HP) occurring at a certain frequency of the supply current of said at least one speaker (HP), said circuit comprising at least one non-inverting converter ($A_0$) arranged upstream of said at least one speaker (HP), the converter having a positive supply terminal linked to the input power supply of the circuit and a negative supply terminal, said circuit also comprising, at the output of said at least one speaker (HP), a first instrumentation ground circuit (GND.a) downstream of the speaker as a bypass from a feedback loop connecting the input point of the ground circuit downstream of the speaker (HP) to the negative supply terminal of the non-inverting converter ($A_0$), the device for filtering the resonance peak of said at least one speaker (HP) being purely electrical in the form of an impedance ($Z_b$, $Z_2$) incorporated either into the first instrumentation ground circuit (GND.a) or into the feedback loop, the parameters of the impedance ($Z_b$, $Z_2$) being predetermined on the basis of the resonance peak to be filtered of said at least one speaker (HP), **characterized in that**:

- when the impedance ($Z_b$) is incorporated into the first instrumentation ground circuit (GND.a), this impedance ($Z_b$) is in the form of a dead resistor ($R_0$) associated with a first impedance called parallel RLC ($Z_{bb}$) comprising at least one first resistor ($R_b$), at least one first inductor ($L_b$) and at least one first capacitor ($C_b$) arranged in parallel with one another, the first parallel RLC impedance ($Z_{bb}$) being arranged in series with the dead resistor ($R_0$) in said first instrumentation ground circuit (GND.a), and
- when the impedance ($Z_2$) is incorporated into the feedback loop, this impedance, as second impedance ($Z_2$), comprises an associated second resistor ($R_2$) in parallel with at least one second inductor ($L_2$) and at least one second capacitor ($C_2$), said at least one second inductor ($L_2$) and said at least one second capacitor ($C_2$) being arranged in series.

2. Circuit according to the preceding claim, wherein, when the impedance ($Z_b$) is incorporated into the first instrumentation ground circuit (GND.a), the values of said at least one first capacitor ($C_b$), of said at least one first resistor ($R_b$) and of said at least one first inductor ($L_b$) are calculated according to the parameters of said at least one speaker (HP), that is to say the ratio $f_m/M_m$ representative of the attenuation and the ratio $k_m/M_m$ representative of the square of the resonant angular frequency of said at least one speaker (HP), using the following equations:

$$f_m/M_m = 1/R_b.C_b$$

$$k_m/M_m = 1/L_b.C_b$$

where $M_m$ represents the moving mass of the speaker, $f_m$ is a constant by which the damping force of the speaker is proportional to the speed of movement of the speaker, and $k_m$ represents a suspension mechanics stiffness of the speaker.

3. Circuit according to the preceding claim, wherein the value of the dead resistor ($R_0$) is calculated using the following equation:

$$R_0 = \frac{1}{C_b} \cdot \frac{1}{\sqrt{2 \cdot k_m/M_m - f_m/M_m}}$$

4. Circuit according to any one of the three preceding claims, wherein the first parallel RLC impedance ($Z_{bb}$) comprises n first inductors ($L_b$) and n first capacitors ($C_b$), n being greater than or equal to one.

5. Circuit according to the preceding claim, wherein, when the impedance ($Z_2$) is incorporated into the feedback loop, a second instrumentation ground circuit is arranged between the second impedance ($Z_2$) and the converter ($A_0$), the first and second instrumentation ground circuits respectively incorporating a first dead resistor ($R_B$) for the first instrumentation ground circuit and a second dead resistor ($R_3$) for the second instrumentation ground circuit.

6. Circuit according to the preceding claim, wherein the device is calibrated on the basis of the value of the first dead resistor ($R_B$), the value of the second resistor ($R_2$) of the second impedance ($Z_2$) being determined on the basis of the value of the first dead resistor ($R_B$) while being 10 to 100 times greater than the value of the first dead resistor ($R_B$), the value of the second dead resistor ($R_3$) being 2 to 30 times greater than the value of the first dead resistor ($R_B$).

7. Circuit according to any one of Claims 1, 5 or 6, wherein, when the value of said at least one second inductor ($L_2$) exceeds a value of 50 mH, said at least one second inductor ($L_2$) is in the form of virtual inductors equipped with gyrator means.

**FIG. 1**

**FIG. 2**

**FIG. 3**

**FIG. 4**

FIG. 5

FIG. 5a

$$V_f = \beta . V_0 \qquad V_0 = \frac{1}{\beta} . V_{in}$$

**FIG. 6**

$$\frac{I}{V_{in}} = \frac{(R_B + Z_2 + R_3)}{R_B \cdot R_3}$$

**FIG. 7**

FIG. 8

FIG. 9

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- FR 2422309 A

- GB 2473921 A

**Littérature non-brevet citée dans la description**

- **ESA MERILÄINEN.** *Current-driving of loudspeakers - Eliminating major distortion and interference effects by the physically correct operation method,* 08 Février 2010, ISBN 1450544002